Europäisches Patentamt

European Patent Office

Office européen des brevets

(11) Publication number: **0 122 631**
**B1**

(12) **EUROPEAN PATENT SPECIFICATION**

(45) Date of publication of patent specification: **31.10.90**

(21) Application number: **84104298.9**

(22) Date of filing: **16.04.84**

(51) Int. Cl.⁵: **H 01 L 23/52, H 01 L 23/28**

(54) Electronic device having a multi-layer wiring structure.

(30) Priority: **15.04.83 JP 65337/83**

(43) Date of publication of application:
**24.10.84 Bulletin 84/43**

(45) Publication of the grant of the patent:
**31.10.90 Bulletin 90/44**

(84) Designated Contracting States:
**DE FR GB IT**

(56) References cited:
**EP-A-0 021 818**
**DE-A-2 637 667**
**DE-A-3 026 026**
**DE-A-3 141 000**
**US-A-4 001 871**

(73) Proprietor: **HITACHI, LTD.**
**6, Kanda Surugadai 4-chome**
**Chiyoda-ku, Tokyo 100 (JP)**
(73) Proprietor: **HITACHI MICROCOMPUTER**
**ENGINEERING LTD.**
**1479, Josuihon-cho**
**Kodaira-shi Tokyo (JP)**

(72) Inventor: **Fujioka, Kazumichi**
**1390-9, Iizuka-machi**
**Takasaki-shi Gunma (JP)**
Inventor: **Kato, Tokio**
**3-45, Hirai-cho**
**Kiryu-shi Gunma (JP)**
Inventor: **Takahashi, Eiichi**
**I-196-go, 768 Shimoshinden-machi**
**Maebashi-shi Gunma (JP)**

(74) Representative: **Strehl, Peter, Dipl.-Ing. et al**
**Patentanwälte Strehl Schübel-Hopf Groening**
**Maximilianstrasse 54 Postfach 22 14 55**
**D-8000 München 22 (DE)**

## Description

The present invention relates to a wiring technique, more particularly to a technique particularly effective to a multi-layer wiring, and to an electronic device having a muti-layer wiring structure such as a resin-molded semiconductor integrated circuit device having a multi-layer wiring structure.

A semiconductor device having a multi-layer wiring structure has been well known by, for example, U.S. Patent 4,001,870. In this patent, an organic material such as polyimide is used as an interlayer insulation film.

The polyimide resin, however, has a shortcoming in that it includes moisture and aluminum, if it is used as a wiring material, is corroded by the moisture. Further, since it is difficult to form a thin layer, contact holes in the interlayer insulation film (polyimide resin film) are necessarily large. As a result, the miniaturization is hard to attain.

Accordingly, a semiconductor integrated circuit device having a high reliability and a high density cannot be obtained.

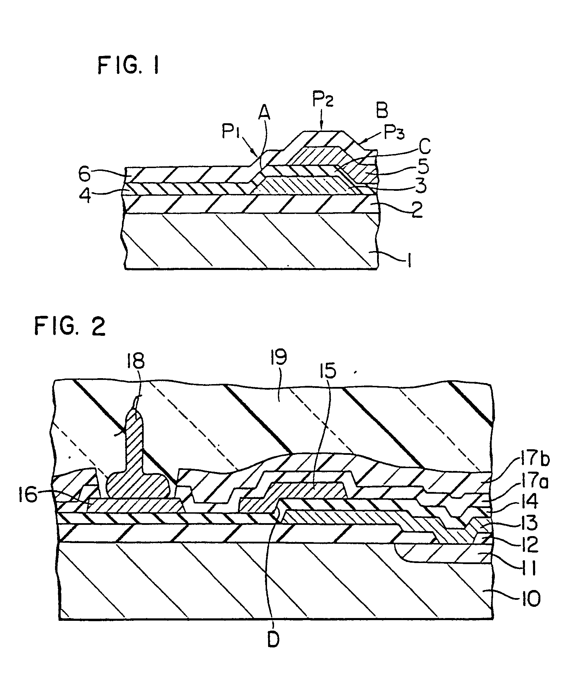

In order to provide a semiconductor integrated circuit device having a high reliability and a high density wiring structure, the inventors of the present invention studied the use of a layer structure as disclosed in the laid open German patent application 2 637 667 with an inorganic material such as CVD-PSG (chemical vapor deposition-phosphorus silicate glass) as an interlayer insulation film 4 and a protection layer 6 to protect the topmost wiring layer (second level wiring 5) as shown in Fig. 1. However, the following new problem occurred.

In order to reduce a cost of the semiconductor integrated circuit device, resin was used as a packaging (molding) material and the resin was package-molded by a well-known transfer mold method. However, since the softened resin is press-inserted into a mold in the transfer mold method, pressures P1, P2 and P3 are applied to the protection layer 6 as shown in Fig. 1, and the protection layer 6 and the interlayer insulation film 4 are cracked by a stress created when the resin is cured and a thermal stress created during a heat cycle test after the resin molding. The cracks occurred at areas B and C of the interlayer insulation film 4 and particularly at a stepped area A. In the stepped area A, many cracks occurred at regions where an edge of the second level wiring 5 runs closely to an edge of a first level wiring 3.

As a result, moisture penetrated from a portion of the cracked protection layer 6 or a portion of the cracked interlayer insulation film 4 and it eroded the aluminum wirings 3 and 5 and shorted the first level wiring 3 and the second level wiring 5, and the semiconductor integrated circuit device having the high reliability was not provided. In Fig. 1, numeral 1 denotes a semiconductor (Si) substrate and numeral 2 denotes a thermal oxidization film (SiO$_2$ film).

It is an object of the present invention to provide an electronic device having a highly reliable multi-layer wiring structure.

It is another object of the present invention to provide a highly reliable and high density resin-molded semiconductor integrated circuit device.

It is another object of the present invention to provide a compact resin-molded semiconductor integrated circuit device.

It is another object of the present invention to provide a bipolar semiconductor integrated circuit device having a high reliability and a high density.

The above objects are met by the invention as defined in claim 1.

The present invention will be apparent from the following detailed description taken in conjunction with the accompanying drawings, in which:

Fig. 1 is a partial sectional view of a semiconductor integrated circuit device considered prior to the present invention;

Fig. 2 is a partial sectional view of a resin-molded semiconductor integrated circuit device in accordance with one embodiment of the present invention;

Fig. 3 is a perspective view of the resin-molded semiconductor integrated circuit device (an external view of a package) of the present invention;

Fig. 4 is a perspective view of a semiconductor wafer;

Fig. 5 is a partial, enlarged sectional view of the semiconductor wafer shown in Fig. 4; and

Fig. 6 is a partial sectional view of a semiconductor integrated circuit device before the resin-molding in accordance with other embodiments of the present invention.

Fig. 2 shows a partial sectional view of a semiconductor integrated circuit device having a two-layer wiring structure, which is a most typical embodiment of the present invention.

In Fig. 2, numeral 10 denotes a substrate of an electronic device. For a bipolar semiconductor integrated circuit device, it is a semiconductor substrate, and more specifically it is an N-type epitaxial semiconductor layer formed on a P-type silicon substrate (not shown). Numeral 11 denotes a P-type semiconductor region selectively formed in the N-type epitaxial semiconductor layer 10 by a conventional diffusion technique or ion implantation technique.

In an actual semiconductor integrated circuit device, not only the P-type semiconductor region 11 but also an isolation region and a buried region are formed, although those regions are omitted in Fig. 2. An example of the present semiconductor integrated circuit device is an LS-TTL (low power Schottky transistor-transistor logic) circuit.

Numeral 12 denotes a silicon dioxide (SiO$_2$) film formed by thermally oxidizing the surface of the epitaxial semiconductor layer 10. The SiO$_2$ film 12 is used as a mask for selectively forming the P-type region 11. A first level wiring 13 (having a thickness of 1.0—1.4 µm) is formed on the SiO$_2$ film 12. A portion of the wiring 13 contacts to the P-type semiconductor region 11. Pure aluminum is used for the wiring 13. An insulation film 14 is formed as an interlayer insulation film on the entire surface of the epitaxial semiconductor layer or the semiconductor substrate 10 to protect the wiring 13. The interlayer insulation film 14 is an inorganic laminated structure of a CVD-PSG film (having a thickness of 600 nm (corresponding to 6000 Å)), an SOG (spin-on-glass) film (having a thickness of 200 nm (2000 Å)) and a P-SiN (plasma nitride) film (having a thickness of 240 nm (2400 Å)). The P-SiN film is first formed to cover the wiring 13. The P-SiN film is used as the interlayer insulation film because of a low defect density such as pinholes. The P-SiN film is also effective to prevent hill-rock of the aluminum (wiring 13). After the formation of the wiring 13, heat treatment called contact alloying (for example, at 470—490°C for 15 minutes) is usually carried out to assure a perfect ohmic contact between the wiring 13 and the semiconductor region. During the heat treatment (contact alloying), the hillrock of the aluminum occurs. However, when the P-SiN film is formed and then the contact alloying is carried out, the hillrock is prevented by the P-SiN film. The thickness of the P-SiN film is preferably 100 nm—300 nm (1000 Å—3000 Å). The SOG film or the insulative glass film is formed on the P-SiN film by a rotating coating method. If the SOG film is too thick, a crack will occur therein. Accordingly, the thickness is preferably 80 nm—200 nm (800 Å—2000 Å). The CVD-PSG film is formed on the SOG film. The CVD-PSG film is used to passivate the semiconductor surface by a gettering effect of phosphorous. The thickness of the CVD-PSG film is preferably 500 nm—1000 nm (5000 Å—10000 Å). A concentration of $P_2O_5$ contained in the CVD-PSG film is preferably 4—6 mol%. In the present embodiment, it is 6 mol%.

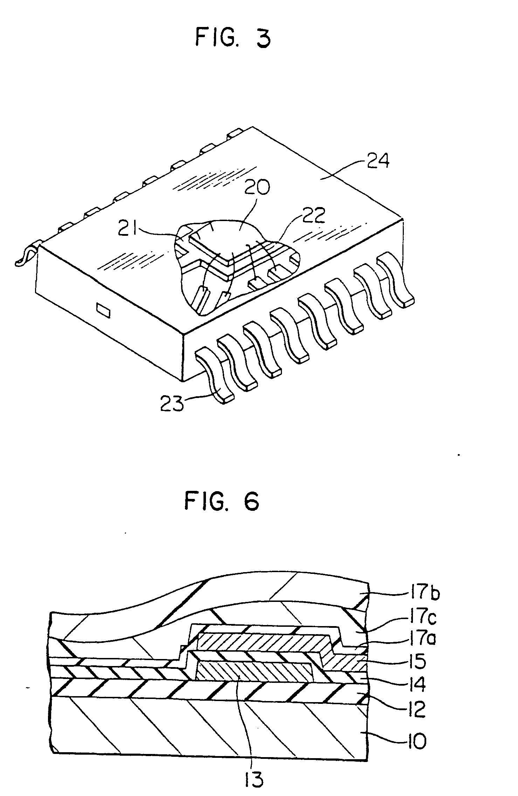

A second level wiring 15 (having a thickness of 1.7—2.0 μm) and a bonding pad 16 formed by simultaneous patterning with the wiring 15 are formed on the laminated interlayer insulation film 14. Aluminum containing Si is used for the wiring 15 and the bonding pad 16 for anti-corrosion purpose. The aluminum containing the Si is deposited by a sputtering method to improve a step coverage. A CVD-PSG film 17a (having a thickness of 120 nm (1200 Å)) is formed as a final passivation layer on the wiring 15, and an organic resin fiLm 17b such as a polyimide resin film (having a thickness of approximately 3.8 μm) is formed on the CVD-PSG film in accordance with the feature of the present invention. Polyimide isoindro quinazolinedione (PIQ, trademark of Hitachi Chemical Co., Ltd.) is preferable for the polyimide resin film 17b. The CVD-PSG film 17a formed for final passivation underlying the polyimide resin film 17b is intended to protect the second level wiring 15 by the relatively hard passivation film so that it is not broken by the pressure during the molding. It also serves to enhance anti-humidity property. If the polyimide resin is deposited directly on the second level wiring 15, the wiring 15 may be broken by displacement by the pressure during the molding because the polyimide resin is soft. Further, since the polyimide resin contains moisture, the aluminum may be eroded. Accordingly, the CVD-PSG film 17a is formed on the wiring 15 to prevent the above problems. A concentration of $P_2O_5$ contained in the CVD-PSG film 17a to prevent the deterioration of the anti-humidity property is 4 mol% which is lower than the concentration of $P_2O_5$ in the CVD-PSG used as the interlayer insulation film. While not shown, a $CVD-SiO_2$ film having a thickness of approximately 200 nm (2000 Å) is formed between the CVD-PSG film 17a and the polyimide resin film in order to further prevent the deterioration of the anti-humidity property and maintain an appropriate hardness. The thickness of the polyimide resin film need not be very large and preferably 4—6 μm, taking an etching time into consideration. The CVD-PSG film 17a and the polyimide resin film 17b are selectively etched through a common pattern mask to expose the bonding pad 16. An Au wire 18 or an Al wire is bonded to the bonding pad 16 by a nail head bonding or ultrasonic bonding method. The other end of the wire is bonded to an end of a lead (not shown). This will be readily understood from the explanation of Fig. 3 to be made later. The wire-bonded electronic device or semiconductor pellet is molded or packaged by a thermo-setting resin 19 such as epoxy resin composition. The packaging may be done by a well-known transfer mold method. Fig. 3 shows a perspective view of the resin-molded semiconductor integrated circuit device of the present invention. Fig. 3 shows a thin package called an SOP (small outline package) and leads 23 are coated with solder. Numeral 20 denotes a semiconductor pellet having a multi-layer wiring structure and numeral 21 denotes a tab for supporting the semiconductor pellet 20. The semiconductor pellet 20 is bonded to the tab 21 by Ag paste. Numeral 22 denotes a wire and numeral 24 denotes the resin mold formed by the transfer molding method.

The resin-molded semiconductor integrated circuit device of the present embodiment was subjected to a reliability test such as a temperature cycle lifetime test.

(1) Test method:
Temperature cycle lifetime (Samples to be tested were alternately placed in a high temperature chamber (150°C) and a low temperature chamber (−55°C) and the occurrence of cracks in the interlayer insulation film was examined).

(2) Samples tested and the number of samples tested:

Samples A (comparative samples having final passivation films consisting of the CVD-PSG)     30

Sample B (inventive samples having the final passivation films of the two-layer structure of CVD-PSG and PIQ)     30

(3) Test result:

| | Samples A | Samples B |
|---|---|---|
| 200 cycles | 13/30 | 0/30 |
| 500 cycles | 7/17 | 0/30 |
| 1,000 cycles | 4/10 | 0/30 |
| 2,000 cycles | 1/6 | 0/30 |

The test result shows the number of cracked samples/number of samples tested.

As seen from the above test result, according to the present invention, the soft polyimide resin absorbs the stress created between the molding resin and the semiconductor pellet by the thermal stress and reduces the stress applied to the interlayer insulation film under the polyimide resin. As a result, no crack occurs in the inorganic interlayer insulation film 14 and the CVD-PSG film 17 (final passivation). Since no crack occurs in the interlayer insulation film at a step D, the first level wiring 13 (lower wiring) and the second level wiring 15 (upper wiring) do not short to each other. Another reason for no cracking at the step D may be that the interlayer insulation film includes the SOG deposited by coating. By the use of the SOG film, the step of the interlayer insulation film can be relieved and the crack at the step D is further prevented.

Accordingly, the present embodiment provides the semiconductor integrated circuit device having a high reliability and a high density wiring structure. Since the anti-thermal stress property is enhanced by the present embodiment, the resin-molded semiconductor integrated circuit device may be dipped in a solder bath when the leads are soldered.

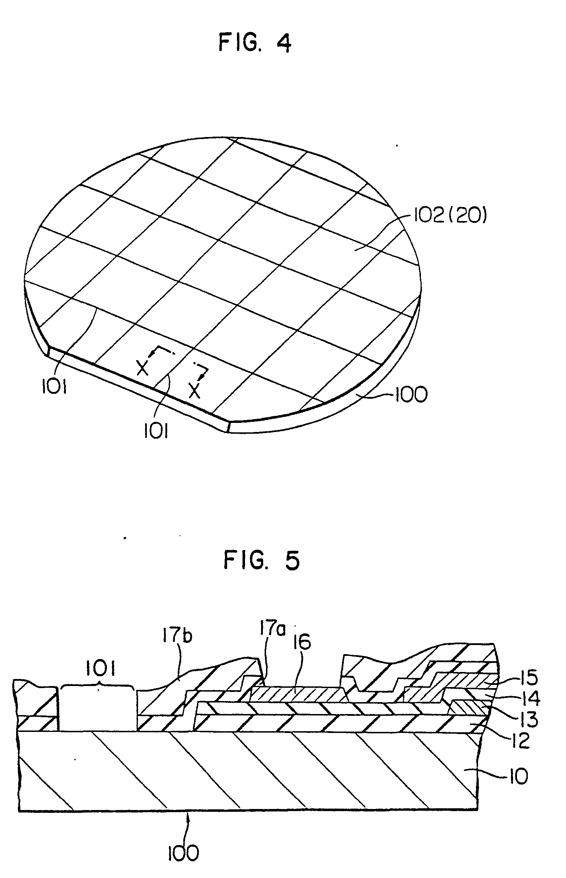

In the present embodiment, the polyimide resin film 17b is formed on an entire main surface of a semiconductor wafer 100 shown in Fig. 4, except on scribe-line areas 101 and bonding pad areas (not shown). A square block 102 encircled by the scribe lines 101 corresponds to the semiconductor pellet (or called a semiconductor chip) 20 shown in Fig. 3. Fig. 5 shows a partial enlarged sectional view (taken along a line X—X of the semiconductor wafer shown in Fig. 4) of the semiconductor wafer 100 in the vicinity of the scribe line 101. As shown in Fig. 5, the edges of the $SiO_2$ film 12 and the interlayer insulation film 14 in the vicinity of the scribe line 101 are coated with the final passivation film comprising the CVD-PSG film 17a and the polyimide resin film 17b. Accordingly, the penetration of the moisture from the edge is prevented and the anti-humidity property is improved.

The present embodiment further offers the following advantages.

When the semiconductor wafer 101 is divided into the semiconductor pellets 20, it is diced along the scribe lines 101. Fine particles of the semiconductor wafer scatter during this work, but the second level wiring 15 is protected by the polyimide resin film 17b. Since the polyimide resin film 17b is the soft organic resin film, no crack occurs therein by the fine particles.

Since the main surface of the semiconductor pellet is protected by the soft organic resin film, the handling of the semiconductor pellet is very easy.

While the preferred embodiment of the present invention has been described in detail, the present invention is not limited to the above embodiment but various modifications may be made without departing from the scope of the invention. For example, the following modifications may be made.

(a) Fig. 6 shows a partial sectional view of a semiconductor integrated circuit device having a multi-layer wiring structure in accordance with other embodiments of the present invention. In the semiconductor integrated circuit device of Fig. 6, an insulative glass film such as SOG film 17c is interposed between the CVD-PSG film 17a and the polyimide resin film 17b. By interposing the glass film 17c, the step is relieved so that the cracking in the interlayer insulation film is further prevented. This final passivation structure (17a, 17c, 17b) is effectively applicable to the three-layer or multi-layer wiring structure having a steep step.

(b) In the above embodiment, the polyimide resin is formed prior to the wire bonding. In the present embodiment, the final passivation comprises only the CVD-PSG film, and the polyimide resin is coated by potting on the main surface of the semiconductor pellet after the wire bonding and before the molding.

(c) In the above embodiment, the semiconductor region formed in the semiconductor substrate forms the bipolar IC. Alternatively, the semiconductor region may form a MIS IC (or also called MOS IC). It may also form a Bi-MOS IC which contains the bipolar IC and the MOS IC in one semiconductor substrate. The multi-layer wiring structure of the semiconductor integrated circuit device which contains MIS FET's such as the MIS IC or the Bi-CMOSIC is explained with reference to Fig. 2.

In Fig. 2, the thickness of the first level wiring 13 and the second level wiring 15 (bonding pad 16) is 0.8 μm. The interlayer insulation film 14 is an inorganic insulative film having a three-layer structure of a plasma $SiO_2$ film (having a thickness of 200 nm (2,000 Å)), an SOG film (having a thickness of 115 nm (1,150 Å)) and a CVD-PSG film (having a thickness of 600 nm (6,000 Å)), from the bottom to the top. In the semiconductor integrated circuit device which contains the MIS FET's, the plasma $SiO_2$ (P-$SiO_2$) film is used instead of the P-SiN film in order to prevent the variation and the deterioration of the electrical characteristic of the MIS FET's. Like the P-SiN film, the P-$SiO_2$ film is formed to prevent the hillrock of the aluminum. The thickness of the CVD-PSG film 17a used as the final passivation is 200 nm (2,000 Å), and the thickness of the polyimide resin film 17b, for example, PIQ is approximately 2.3—3.75 μm. A P-SiN film having a thickness of 1.1 μm is interleaved between the CVD-PSG film 17a and the polyimide resin film 17b in order to improve the anti-humidity property.

(d) Photosensitive polyimide may be used for the polyimide resin film 17b. No photo-resist is required for the photosensitive polyimide in the selective etching process. Accordingly, the number of steps can be reduced by the use of the photosensitive polyimide.

(e) One resin selected from silicone resin, imide silicone resin, teflon and polyethylene, or a combination thereof may be used as the final passivation film 17b to form the multi-layer structure film.

## Claims

1. A resin molded semiconductor device having a multi-layer wiring structure comprising an inorganic insulating film (14) between a lower wiring (13) and an upper wiring (15), an organic resin film (17b) formed over said upper wiring (15) and an epoxy resin used as a mold resin (19),

characterized in that a phosphorus silicate glass film (17a) is formed between said upper wiring and said organic resin film.

2. A semiconductor device according to claim 1, wherein said organic resin film (17b) is a polyimide resin film.

3. A semiconductor device according to claim 1 or 2, wherein said resin mold (19) is formed by a transfer molding technique.

4. A semiconductor device according to any of claims 1 to 3, wherein said inorganic insulating film (14) is composed of a plasma insulation film, an insulating glass film and a phosphorus silicate glass film.

5. A semiconductor device according to any of claims 1 to 4, wherein an insulating glass film (17c) is interposed between said organic resin film (17b) and said phosphorus silicate glass film (17a).

6. A semiconductor device according to any of claims 1 to 5, wherein an $SiO_2$ film or an SiN film or a spin-on-glass film is formed between the phosphorus silicate glass film (17a) and the organic resin film (17b).

## Patentansprüche

1. In Kunstharz eingeformte Halbleitereinrichtung mit einer Mehrschsicht-Verdrahtungsstruktur, umfassend einen anorganischen Isolierfilm (14) zwischen einer unteren Verdrahtung (13) und einer oberen Verdrahtung (15), einen über der oberen Verdrahtung (15) ausgebildeten organischen Kunstharzfilm (17b) und ein als Einformungs-Kunstharz (19) dienendes Epoxyharz,

dadurch gekennzeichnet, daß zwischen der oberen Verdrahtung und dem organischen Kunstharzfilm ein Phosphorsilikatglasfilm (17a) ausgebildet ist.

2. Halbleitereinrichtung nach Anspruch 1, wobei der organische Kunstharzfilm (17b) ein Polyimidharzfilm ist.

3. Halbleitereinrichtung nach Anspruch 1 oder 2, wobei die Kunstharzeinformung (19) durch Spritzpressen gebildet ist.

4. Halbleitereinrichtung nach einem der Ansprüche 1 bis 3, wobei der anorganische Isolierfilm 14) aus einem Plasma-Isolierfilm, einem isolierenden Glasfilm und einem Phosphorsilikatglasfilm zusammengesetzt ist.

5. Halbleitereinrichtung nach einem der Ansprüche 1 bis 4, wobei zwischen dem organischen Kunstharzfilm (17b) und dem Phosphorsilikatglasfilm (17a) ein isolierender Glasfilm (17c) angeordnet ist.

6. Halbleitereinrichtung nach einem der Ansprüche 1 bis 5, wobei zwischen dem Phosphorsilikatglasfilm (17a) und dem organischen Kunstharzfilm (17b) ein $SiO_2$-Film oder ein SiN-Film oder ein Spin-on-Glas-Film ausgebildet ist.

## Revendications

1. Dispositif à semiconducteurs enrobé dans une résine et possédant une structure de câblage à couches multiples comprenant une pellicule isolante minérale (14) disposée entre un câblage inférieur (13) et un câblage supérieur (15), une pellicule de résine organique (17b) formée sur ledit câblage supérieur (15), et une résine époxy utilisée comme résine d'enrobage (19),

caractérisé en ce qu'une pellicule de verre aux phosphosilicates (17a) est formée entre ledit câblage supérieur et ladite pellicule de résine organique.

2. Dispositif à semiconducteurs selon la revendication 1, dans lequel ladite pellicule de résine organique (17b) est une pellicule de résine polyimide.

3. Dispositif à semiconducteurs selon la revendication 1 ou 2, dans lequel ledit enrobage en résine (19) est formé au moyen d'une technique de moulage par transfert.

4. Dispositif à semiconducteurs selon l'une quelconque des revendications 1 à 3, dans lequel ladite pellicule isolante minérale (14) est constituée par une pellicule isolante de plasma, une pellicule isolante en verre et une pellicule de verre aux phosphosilicates.

5. Dispositif à semiconducteurs selon l'une quelconque des revendications 1 à 4, dans lequel une pellicule isolante en verre (17c) est intercalée entre ladite pellicule de résine organique (17b) et ladite pellicule de verre aux phosphosilicates (17a).

6. Dispositif à semiconducteurs selon l'une quelconque des revendications 1 à 5, dans lequel une pellicule de $SiO_2$ ou une pellicule de SiN ou une pellicule de verre avec spin est formée entre la pellicule de verre aux phosphosilicates (17a) et la pellicule de résine organique (17b).

FIG. 1

FIG. 2

FIG. 3

FIG. 6

## FIG. 4

102(20)

101

101

100

## FIG. 5

17b    17a   16

101

15
14
13
12

10

100